# EUROPEAN PATENT APPLICATION

(11) **EP 4 502 072 A1**
(43) Date of publication of application: **05.02.2025**
(21) Application number: 23774989.0
(22) Date of filing: 23.03.2023
(51) Int. Cl.: C08L 101/00, C08K 3/04, C08K 7/06

(54) **RESIN COMPOSITION, AND RESIN MOLDED BODY**

(30) Priority: 25.03.2022 JP 2022050161
(71) Applicant: Sekisui Techno Molding Co., Ltd., Minato-ku, Tokyo 105-8566 (JP)
(72) Inventor: MATSUMURA, Ryuuji, Toyohashi-shi, Aichi 441-8123 (JP); NISHIKAWA, Fumiya, Toyohashi-shi, Aichi 441-8123 (JP)
(74) Representative: Ter Meer Steinmeister & Partner
(86) International application number: PCT/JP2023/011367
(87) International publication number: WO 2023/182394

(57) **Abstract**

Provided is a resin composition capable of achieving both mechanical strength such as bending strength and electromagnetic wave shielding properties at a high level. A resin composition including: a thermoplastic resin (A); carbon black (B); carbon fibers (C); and graphite (D), in which a content of the carbon black (B) is from 10 parts by weight or more and 100 parts by weight or less with respect to 100 parts by weight of the thermoplastic resin (A).

## Description

### TECHNICAL FIELD

The present invention relates to a resin composition and a resin molded body using the resin composition.

### BACKGROUND ART

Conventionally, a metal plate, a resin molded body having thermal conductivity, or the like is used for a communication device used indoors or outdoors, a housing of an electronic device such as a security camera or a smart meter, a multi-information display such as a car navigation system or a smart meter, a heat dissipation chassis of an in-vehicle camera, an LED heat dissipation heat sink, an SoC, or a heat dissipation plate such as a GDC. Note that the SoC refers to "System-on-a-chip", and the GDC refers to "Graphics Display Controller".

Patent Document 1 below discloses a molded body obtained by molding a resin pellet containing a thermoplastic resin and carbon fibers. In Patent Document 1, the thermoplastic resin is a crystalline resin. The carbon fibers include a PAN-based carbon fiber and a pitch-based carbon fiber. A mass average fiber length of the carbon fibers in the resin pellet is 0.1 mm to 0.9 mm. Bending strength of the molded body is 280 MPa or more.

### Related Art Document

### Patent Document

Patent Document 1: JP 2020-079412 A

### SUMMARY OF THE INVENTION

### PROBLEMS TO BE SOLVED BY THE INVENTION

In recent years, with the increase in speed of the CPU, a resin molded body having electromagnetic wave shielding properties higher than that in the related art is required.

However, the resin composition as in Patent Document 1 has a problem that it is difficult to achieve both mechanical strength such as bending strength and electromagnetic wave shielding properties at a high level when the resin composition is formed into a molded body.

An object of the present invention is to provide a resin composition capable of achieving both mechanical strength such as bending strength and electromagnetic wave shielding properties at a high level, and a resin molded body using the resin composition.

### MEANS FOR SOLVING THE PROBLEMS

The resin composition according to the present invention contains a thermoplastic resin (A); carbon black (B); carbon fibers (C); and graphite (D), in which a content of the carbon black (B) is from 10 parts by weight or more and 100 parts by weight or less with respect to 100 parts by weight of the thermoplastic resin (A).

In a specific aspect of the resin composition according to the present invention, a content of the carbon fibers (C) is 10 parts by weight or more and 100 parts by weight or less with respect to 100 parts by weight of the thermoplastic resin (A).

In another specific aspect of the resin composition according to the present invention, a BET specific surface area of the carbon black (B) is 600 m²/g or less.

In still another specific aspect of the resin composition according to the present invention, a weight average fiber length of the carbon fibers (C) is 0.5 mm or more and 15 mm or less.

In still another specific aspect of the resin composition according to the present invention, the carbon black (B) is oil-furnace black.

In still another specific aspect of the resin composition according to the present invention, a content of the graphite (D) is 10 parts by weight or more and 200 parts by weight or less with respect to 100 parts by weight of the thermoplastic resin (A).

In still another specific aspect of the resin composition according to the present invention, when a mold is filled with the resin composition in a molten state from a direction orthogonal to a thickness direction of a resin molded body to be obtained and molded to obtain a resin molded body of 100 mm length × 100 mm width × 2 mm thickness, an electromagnetic wave shielding effect at a frequency of 100 MHz of the resin molded body is 20 dB or more, and when the resin composition is molded in accordance with ISO294-1 to obtain a strip-shaped resin molded body, a bending strength of the strip-shaped resin molded body measured in accordance with ISO178 is 40 MPa or more.

In still another specific aspect of the resin composition according to the present invention, when a mold is filled with the resin composition in a molten state from a direction orthogonal to a thickness direction of a resin molded body to be obtained and molded to obtain a resin molded body of 100 mm length × 100 mm width × 2 mm thickness, the thermal conductivity in in-plane direction in a main surface of the resin molded body is 1.0 W/(m-K) or more.

The resin molded body according to the present invention is a molded body of a resin composition configured according to the present invention.

In a specific aspect of the resin molded body according to the present invention, the resin molded body has a heat dissipation chassis, a heat dissipation housing, or a heat sink shape.

### EFFECT OF THE INVENTION

According to the present invention, it is possible to provide a resin composition capable of achieving both mechanical strength such as bending strength and electromagnetic wave shielding properties at a high level, and a resin molded body using the resin composition.

### BRIEF DESCRIPTION OF DRAWINGS

[Fig. 1] Fig. 1 is a schematic perspective view illustrating a heat dissipation chassis.
[Fig. 2] Fig. 2 is a schematic perspective view illustrating a heat dissipation housing.
[Fig. 3] Fig. 3 is a schematic perspective view illustrating a heat sink shape.

### MODE FOR CARRYING OUT THE INVENTION

Hereinafter, details of the present invention will be described.

### [Resin composition]

A resin composition of the present invention contains a thermoplastic resin (A), carbon black (B), carbon fibers (C), and graphite (D). A content of the carbon black (B) is 10 parts by weight or more and 100 parts by weight or less with respect to 100 parts by weight of the thermoplastic resin (A).

The resin composition of the present invention contains the thermoplastic resin (A), the carbon black (B), the carbon fiber (C), and the graphite (D), and particularly contains the carbon black (B) in the above specific content, so that both the mechanical strength such as bending strength and the electromagnetic wave shielding properties can be achieved at a high level.

When the resin composition of the present invention is molded in accordance with ISO294-1 to obtain a strip-shaped resin molded body, the bending strength of the strip-shaped resin molded body is preferably 40 MPa or more, more preferably 50 MPa or more, still more preferably 60 MPa or more, and particularly preferably 90 MPa or more. The upper limit of the bending strength of the resin molded body is not particularly limited, but may be, for example, 250 MPa.

The bending strength can be measured in accordance with ISO178. For the measurement of the bending strength, for example, a Tensilon universal tester (Manufactured by ORIENTEC CO., LTD, model number "RTC-1210A") can be used.

In the present invention, the resin molded body obtained under the following molding conditions has an electromagnetic wave shielding effect at a frequency of 100 MHz of preferably 20 dB or more, more preferably 30 dB or more, and still more preferably 40 dB or more. The upper limit value of the electromagnetic wave shielding effect of the resin molded body at a frequency of 100 MHz is not particularly limited, and is, for example, 100 dB.

### <Molding conditions>

A mold is filled with the resin composition in a molten state from a direction orthogonal to a thickness direction of a resin molded body to be obtained and molded to obtain a resin molded body of 100 mm length × 100 mm width × 2 mm thickness.

The electromagnetic wave shielding effect (electromagnetic wave shielding properties) at a frequency of 100 MHz can be obtained by, for example, KEC (KEC: (abbreviation of "KEC Electronic Industry Development Center").

In the present invention, the thermal conductivity of the main surface of the resin molded body obtained under the molding conditions described above in the in-plane direction is preferably 1.0 W/(m-K) or more, more preferably 1.5 W/(m·K) or more, still more preferably 2.0 W/(m·K) or more, and particularly preferably 3.5 W/(m·K) or more. When the thermal conductivity of the main surface of the resin molded body in the in-plane direction is the above lower limit value or more, the thermal conductivity of the resin molded body to be obtained can be further improved. The upper limit value of the thermal conductivity of the main surface of the resin molded body in the in-plane direction can be, for example, 50 W/(m·K). The main surface of the resin molded body refers to a surface having the largest area among a plurality of surfaces on the outer surface of the resin molded body.

The thermal conductivity of the main surface of the resin molded body in the in-plane direction can be calculated using the following Equation (1). Thermal conductivity (W/(m-K)) = Specific gravity (g/cm3) × Specific heat (J/g-K) × Thermal diffusivity (mm2/s)

The thermal diffusivity can be measured using, for example, "Xenon Flash Laser Analyzer LFA467 HyperFlash" manufactured by NETZSCH Japan K.K.

Hereinafter, each component of the resin composition will be described in detail.

### (Thermoplastic resin (A))

The thermoplastic resin (A) is not particularly limited, and a known thermoplastic resin can be used. Specific examples of the thermoplastic resin (A) include polyolefin, polystyrene, polyacrylate, polymethacrylate, polyacrylonitrile, polyester, polyamide, polyurethane, polyethersulfone, polyetherketone, polyimide, polydimethylsiloxane, polycarbonate, and copolymers containing at least two of these. These thermoplastic resins may be used alone or in combination of two or more thereof. The thermoplastic resin (A) is preferably a resin having a high elastic modulus. The polyolefin (olefin-based resin) and the polyamide (nylon-based resins) are more preferable, and the polyolefin is still more preferable because it is inexpensive and easy to mold under heating.

The polyolefin is not particularly limited, and known polyolefin can be used. Specific examples of the polyolefin include a polyethylene-based resin such as polyethylene which is an ethylene homopolymer, an ethylene-α-olefin copolymer, an ethylene-(meth)acrylic acid copolymer, an ethylene-(meth)acrylic acid ester copolymer, and an ethylene-vinyl acetate copolymer. In addition, the polyolefin may be polypropylene which is a propylene homopolymer, a polypropylene-based resin such as a propylene-α-olefin copolymer, or a homopolymer or copolymer of a conjugated diene such as polybutene, butadiene, or isoprene which is a butene homopolymer. These polyolefins may be used alone or in combination of two or more thereof. From the viewpoint of further enhancing the heat resistance and the elastic modulus, polypropylene is preferable as the polyolefin.

The polyolefin (olefin-based resin) preferably contains an ethylene component. The content of the ethylene component is preferably 5% by mass to 40% by mass. When the content of the ethylene component is within the above range, the heat resistance of the resin molded body can be further enhanced while the impact resistance of the resin molded body is further enhanced.

The MFR of the thermoplastic resin (A) measured in accordance with JIS K 7210 is preferably 10 g/10 min or more, more preferably 20 g/10 min or more, and preferably 200 g/10 min or less, more preferably 150 g/10 min or less, still more preferably 100 g/10 min or less, particularly preferably 50 g/10 min or less. When the MFR is within the above range, the fluidity of the thermoplastic resin (A) can be further enhanced.

The content of the thermoplastic resin (A) in the resin composition is preferably 25° by weight or more and more preferably 30% by weight or more, and preferably 70% by weight or less and more preferably 60% by weight or less. When the content of the thermoplastic resin (A) is within the above range, the moldability of the resin composition can be further enhanced.

### (Carbon black (B))

As the carbon black (B), for example, Ketjen black, oil-furnace black, acetylene black, channel black, thermal black, or the like can be used. Among them, from the viewpoint of further enhancing the conductivity of the resin molded body to be obtained, oil-furnace black is preferable. The ash content of the carbon black (B) is preferably 1% or less. The carbon black (B) may contain metal impurities such as Fe and Ni.

The BET specific surface area of the carbon black (B) is preferably 10 m²/g or more and more preferably 30 m²/g or more, and preferably 1100 m²/g or less, more preferably 600 m²/g or less, still more preferably 400 m²/g or less, and particularly preferably 300 m²/g or less. When the BET specific surface area of the carbon black (B) is the above lower limit value or more, the conductivity of the resin molded body to be obtained can be further enhanced, and the electromagnetic wave shielding properties can be further enhanced. When the BET specific surface area of the carbon black (B) is the above upper limit value or lower, the fluidity of the resin composition during molding can be further improved, and the moldability of the resin composition can be further improved.

The BET specific surface area can be measured from an adsorption isotherm of nitrogen in accordance with the BET method. As the measuring device, for example, a product number "NOVA touch LX2" manufactured by Anton Paar GmbH can be used.

The DBP oil absorption amount of the carbon black (B) is not particularly limited, and is preferably 30 ml/100 g or more and more preferably 50 ml/100 g or more, and preferably 450 ml/100 g or less, more preferably 400 ml/100 g or less, and further preferably 300 ml/100 g or less. When the DBP oil absorption amount of the carbon black (B) is within the above range, the conductivity of the resin molded body to be obtained can be further enhanced, and the electromagnetic wave shielding properties can be further enhanced.

In the present specification, the DBP oil absorption amount of the carbon black (B) can be obtained by calculating the DBP dropping amount at 70% of the maximum torque in accordance with JIS K 6217-4. The DBP oil absorption amount can be measured using, for example, an absorption amount measuring instrument (Product number "S-500" manufactured by ASAHISOUKEN CORPORATION.).

A primary particle size of the carbon black (B) is not particularly limited, and is preferably 5 nm or more and more preferably 10 nm or more, and preferably 70 nm or less and more preferably 60 nm or less. When the primary particle size of the carbon black (B) is within the above range, higher conductivity can be obtained at a lower concentration of the carbon black content.

In the present specification, the primary particle size of the carbon black (B) is, for example, an average primary particle size obtained using image data of the carbon black (B) obtained by a transmission electron microscope. As the transmission electron microscope, for example, a product name "JEM-2200 FS" manufactured by JEOL Ltd. can be used.

The content of the carbon black (B) is 10 parts by weight or more, preferably 15 parts by weight or more, more preferably 20 parts by weight or more, and still more preferably 30 parts by weight or more, and 100 parts by weight or less, preferably 95 parts by weight or less, and more preferably 90 parts by weight or less with respect to 100 parts by weight of the thermoplastic resin (A). When the content of the carbon black (B) is the above lower limit value or more, the conductivity of the resin molded body to be obtained can be further enhanced, and the electromagnetic wave shielding properties can be further enhanced. When the content of the carbon black (B) is the above upper limit or less, the moldability of the resin composition can be further enhanced.

Two or more kinds of carbon blacks may be used as the carbon black (B). For example, carbon black having a BET specific surface area of 600 m²/g or less and carbon black having a BET specific surface area of more than 600 m²/g may be used in combination. In this case, the moldability of the resin composition can be further improved, and the electromagnetic wave shielding properties of the resin molded body to be obtained can be further improved. When the additional amount of carbon black having a BET specific surface area of more than 600 m²/g is too large, the fluidity and moldability of the resin composition may be deteriorated. Therefore, the content of carbon black having a BET specific surface area of more than 600 m²/g is preferably 1 part by weight or more and 30 parts by weight or less with respect to 100 parts by weight of the thermoplastic resin (A).

### (Carbon fiber (C))

The carbon fiber (C) is not particularly limited, but a PAN-based carbon fiber, a pitch-based carbon fiber, or the like can be used. By using the carbon fibers (C), the mechanical strength such as the bending strength and the electromagnetic wave shielding properties of the resin molded body to be obtained can be efficiently enhanced as compared with the case of using other conductive fibers, metal fibers, non-conductive fibers, or resin fibers.

The weight average fiber length of the carbon fibers (C) is preferably 0.5 mm or more, more preferably 2 mm or more, and still more preferably 5 mm or more, and preferably 15 mm or less, more preferably 12 mm or less, and still more preferably 9 mm or less. When the weight average fiber length of the carbon fibers (C) is the above lower limit or more, both the mechanical strength such as the bending strength of the resin molded body to be obtained and the electromagnetic wave shielding properties can be achieved at a higher level. When the weight average fiber length of the carbon fibers (C) is the above upper limit or less, the moldability of the resin composition can be further improved.

The weight average fiber length of the carbon fibers (C) can be, for example, an average value of 100 fibers measured using a transmission electron microscope (TEM) or a scanning electron microscope (SEM).

The fiber diameter of the carbon fibers (C) is preferably 3 µm or more, more preferably 5 µm or more, and preferably 30 µm or less, more preferably 25 µm or less, and still more preferably 20 µm or less. When the fiber diameter of the carbon fibers (C) is within the above range, both the mechanical strength such as the bending strength and the electromagnetic wave shielding properties of the resin molded body to be obtained can be achieved at a higher level.

The fiber diameter of the carbon fibers (C) can be, for example, an average value of 100 fibers measured using a transmission electron microscope (TEM) or a scanning electron microscope (SEM). From the viewpoint of further facilitating the observation, it is desirable to observe the resin with the transmission electron microscope (TEM) or the scanning electron microscope (SEM) after heating a test piece cut out from the resin composition or the resin molded body at 600°C to evaporate the resin.

The content of the carbon fibers (C) is preferably 10 parts by weight or more, more preferably 15 parts by weight or more, still more preferably 20 parts by weight or more, and particularly preferably 35 parts by weight or more, and is preferably 100 parts by weight or less, more preferably 80 parts by weight or less, and still more preferably 70 parts by weight or less with respect to 100 parts by weight of the thermoplastic resin (A). When the content of the carbon fibers (C) is the above lower limit value or more, both the mechanical strength such as the bending strength of the resin molded body to be obtained and the electromagnetic wave shielding properties can be achieved at a higher level. When the content of the carbon fibers (C) is the above upper limit or less, the moldability of the resin composition can be further improved.

### (Graphite (D))

The graphite (D) is not particularly limited, and is preferably plate-like graphite. The plate-like graphite is not particularly limited as long as it is plate-like graphite, and for example, graphite, flaked graphite, graphene, or the like can be used. From the viewpoint of further enhancing the thermal conductivity and the electrical conductivity, graphite or flaked graphite is preferable. These may be used alone or in combination of two or more.

Graphite is a laminate of a plurality of graphene sheets. The number of stacked graphene sheets of graphite is usually about 100,000 to 1 million layers. As such graphite, for example, scale-like graphite can be used. From the viewpoint of further enhancing the flame retardancy, expanded graphite may be used.

The flaked graphite is obtained by peeling the original graphite, and refers to a graphene sheet laminate thinner than the original graphite. The peeling treatment for forming flaked graphite is not particularly limited, and either a mechanical peeling method using a supercritical fluid or the like or a chemical peeling method using an acid may be used. The number of stacked graphene sheets in the flaked graphite may be smaller than that of the original graphite, but is preferably 50 layers or more and more preferably 100 layers or more, and preferably 1000 layers or less, more preferably 500 layers or less, and still more preferably 200 layers or less. When the number of stacked graphene sheets is within the above range, the thermal conductivity and electrical conductivity of the resin molded body to be obtained can be further improved.

The volume average particle size of the plate-like graphite is preferably 5 µm or more, more preferably 30 um or more, and still more preferably 60 pm or more, and preferably 1000 µm or less, more preferably 500 um or less, still more preferably 350 µm or less, and particularly preferably 300 µm or less. When the volume average particle size of the plate-like graphite is within the above range, the thermal conductivity and electrical conductivity of the resin molded body to be obtained can be further improved. When the volume average particle size of the plate-like graphite is the above upper limit value or less, the bending strength of the resin molded body to be obtained can be further improved. As the plate-like graphite, one kind of graphite particles may be used, or two or more kinds of graphite particles having different particle sizes may be used in combination as long as the volume average particle size of the plate-like graphite contained in the resin composition is within the above range.

The volume average particle size refers to a value calculated from a volume-based distribution by a laser diffraction/scattering type particle size distribution measuring apparatus in accordance with JIS Z 8825:2013.

In the measurement of the volume average particle size, for example, the plate-like graphite is put into a soap aqueous solution (containing neutral detergent: 0.01%) so as to have a concentration of 2% by weight, and is irradiated with ultrasonic waves at a power of 300 W for 1 minute using an ultrasonic homogenizer to obtain a suspension. Next, the volume particle size distribution of the plate-like graphite is measured for the suspension by a laser diffraction/scattering type particle size distribution measuring apparatus (Product name "Microtrac MT 3300" manufactured by Nikkiso Co., Ltd.). A cumulative value of 50% of the volume particle size distribution can be calculated as the volume average particle size of the plate-like graphite.

The thickness of the plate-like graphite is preferably more than 1 um and more preferably 5 µm or more, and preferably 50 um or less and more preferably 40 µm or less. When the thickness of the plate-like graphite is within the above range, the thermal conductivity and electrical conductivity of the resin molded body to be obtained can be further enhanced.

The aspect ratio of the plate-like graphite is preferably 5 or more and more preferably 21 or more, and preferably less than 2000, more preferably less than 1000, and still more preferably less than 100. When the aspect ratio of the plate-like graphite is within the above range, the thermal conductivity and electrical conductivity of the resin molded body to be obtained can be further enhanced. In the present specification, the aspect ratio refers to the ratio of the maximum dimension of the plate-like graphite in a stacking plane direction to the thickness of the plate-like graphite.

The thickness of the plate-like graphite can be measured using, for example, a transmission electron microscope (TEM) or a scanning electron microscope (SEM). From the viewpoint of further facilitating the observation, it is desirable to observe the resin with the transmission electron microscope (TEM) or the scanning electron microscope (SEM) after heating a test piece cut out from the resin composition or the resin molded body at 600°C to evaporate the resin. The test piece may be cut out along a direction along the main surface of the resin molded body or may be cut out along a direction orthogonal to the main surface of the resin molded body as long as the thickness of the plate-like graphite can be measured by evaporating the resin.

The content of the graphite (D) is preferably 10 parts by weight or more and more preferably 15 parts by weight or more, and preferably 200 parts by weight or less and more preferably 150 parts by weight or less with respect to 100 parts by weight of the thermoplastic resin (A). When the content of the graphite (D) is the above lower limit value or more, the thermal conductivity and electrical conductivity can be further enhanced. In addition, when the content of the graphite (D) is the above upper limit value or less, the impact resistance can be further enhanced.

### (Other additives)

The resin composition of the present invention may contain various other additives as optional components as long as the effects of the present invention are not impaired. Examples of the additive include antioxidants such as phenol-based, phosphorus-based, amine-based, and sulfur-based antioxidants; ultraviolet absorbers such as benzotriazole-based and hydroxyphenyltriazine-based ultraviolet absorbers; metal inhibitors; various fillers; antistatic agents; stabilizers; and pigments. The resin composition of the present invention may further contain other conductive fibers, metal fibers, non-conductive fibers, resin fibers, or the like as long as the mechanical strength such as bending strength, electromagnetic wave shielding properties, or the like of the resin molded body to be obtained is not impaired. These may be used alone or in combination of two or more.

### (Method for producing resin composition)

The resin composition of the present invention can be obtained by melt-kneading the thermoplastic resin (A), the carbon black (B), the carbon fiber (C), the graphite (D), and if necessary, other additives.

The melt-kneading method is not particularly limited, and examples thereof include a method in which kneading is performed under heating using a kneading apparatus such as a twin-screw kneader such as a plast mill, a single-screw extruder, a twin-screw extruder, a Banbury mixer, a roll, or a pressurizing kneader. Among them, a method for melt-kneading using an extruder is preferable. The form of the resin composition is not particularly limited, and may be, for example, a pellet.

The shape of the pellet is not particularly limited, and examples thereof include a spherical shape, a cylindrical shape, and a prismatic shape. Among them, a cylindrical shape is preferable from the viewpoint of the stability of the pellet shape. When the size of the pellet is, for example, cylindrical, the diameter thereof is preferably 0.5 mm or more and more preferably 1 mm or more, and preferably 5 mm or less and more preferably 3 mm or less. The length is preferably 1 mm or more and more preferably 3 mm or more, and preferably 10 mm or less and more preferably 7 mm or less. The size of the pellet can be measured by randomly collecting 100 particles of the pellet from a sample and using a caliper.

The diameter (pellet diameter) of the pellet of the resin composition other than the cylindrical shape is preferably 1 mm or more and more preferably 5 mm or more, and preferably 15 mm or less and more preferably 10 mm or less. The pellet diameter can be determined by randomly collecting 100 pellets from a sample and measuring the diameter at the longest point using a caliper.

### [Resin molded body]

The resin molded body of the present invention is a molded body of the resin composition of the present invention described above. Therefore, the resin molded body of the present invention can be obtained by molding the resin composition described above.

In the resin molded body of the present invention, since the resin composition of the present invention is used, both mechanical strength such as bending strength and electromagnetic wave shielding properties can be achieved at a high level.

The method for molding the resin composition is not particularly limited, and examples thereof include methods such as press processing, extrusion processing, extrusion lamination processing, and injection molding. Among them, it is preferable to mold a mixture by injection molding.

In the present invention, the bending strength of the resin molded body is preferably 40 MPa or more, more preferably 50 MPa or more, still more preferably 60 MPa or more, and particularly preferably 90 MPa or more. The upper limit value of the bending strength of the resin molded body is not particularly limited, and may be, for example, 250 MPa.

In the present invention, the resin molded body has an electromagnetic wave shielding effect at a frequency of 100 MHz of preferably 20 dB or more, more preferably 30 dB or more, and still more preferably 40 dB or more. The upper limit value of the electromagnetic wave shielding effect of the resin molded body at a frequency of 100 MHz is not particularly limited, and is, for example, 100 dB.

In the present invention, the thermal conductivity of the main surface of the resin molded body in the in-plane direction is preferably 1.0 W/(m-K) or more, more preferably 1.5 W/(m-K) or more, still more preferably 2.0 W/(m·K) or more, and particularly preferably 3.5 W/(m-K) or more. The upper limit value of the thermal conductivity of the main surface of the resin molded body in the in-plane direction can be, for example, 50 W/(m-K).

When the bending strength, the electromagnetic wave shielding effect, the thermal conductivity, and the volume resistivity of the resin molded body of the present invention are measured, the resin molded body is once melted and then re-molded under the following molding conditions.

### <Molding conditions>

A mold is filled with the resin composition in a molten state from a direction orthogonal to a thickness direction of a resin molded body to be obtained and molded to obtain a resin molded body of 100 mm length × 100 mm width × 2 mm thickness.

Since the resin molded body of the present invention is excellent in the electromagnetic wave shielding properties, the resin molded body can be suitably used for housings of communication devices requiring electromagnetic wave shielding properties, and electronic devices such as smart meters and in-vehicle ECUs.

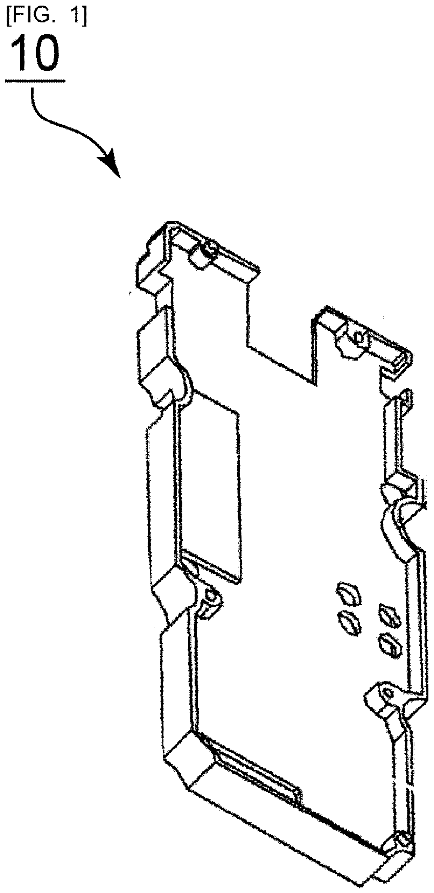

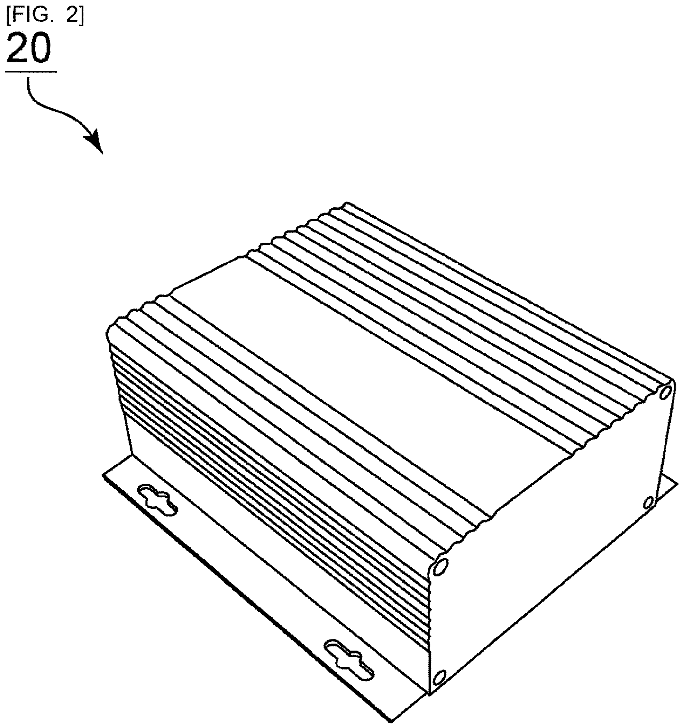

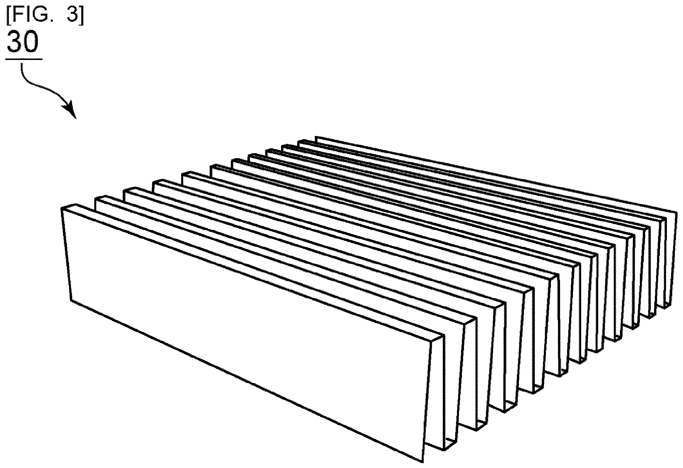

The resin molded body of the present invention is also excellent in heat dissipation. Therefore, the resin molded body of the present invention may be, for example, a heat dissipation chassis 10 as illustrated in Fig. 1, a heat dissipation housing 20 as shown in Fig. 2, or a heat sink 30 as illustrated in Fig. 3.

Further, a circuit may be formed on the surface of such a resin molded body.

Hereinafter, the effects of the present invention will be clarified by giving specific examples and comparative examples of the present invention. Note that the present invention is not limited to the following Examples.

### (Example 1)

100 parts by weight of polypropylene (PP) as the thermoplastic resin (A), 30 parts by weight of oil-furnace black as the carbon black (B), 40 parts by weight of PAN-based carbon fibers as the carbon fibers (C), and 120 parts by weight of scale-like graphite as the graphite (D) were melt-kneaded at 180°C using Labo Plastomill (Product number "R100" manufactured by TOYO SEIKI Co., Ltd.) to obtain a resin composition. The obtained resin composition had a pellet shape and a pellet diameter of 3 mm. The pellet diameter was determined by randomly collecting 100 pellets from a sample and measuring the diameter at the longest point using a caliper. As polypropylene, Product name "BC03B" (MFR: 30 g/10 min (230°C)) manufactured by Japan Polypropylene Corporation was used. As the oil-furnace black, Product name "Vulcan XC-72" (BET specific surface area: 254 m²/g, DBP oil absorption amount: 174 ml/100 g, primary particle size: 30 nm) manufactured by Cabot Corporation was used. As the PAN-based carbon fibers, Product name "TR06U" (weight average fiber length: 6 mm, fiber diameter: 7 µm) manufactured by Mitsubishi Chemical Corporation was used. As the scale-like graphite, "CPB-300" (Product name) (volume average particle size: 300 pm) manufactured by Chuetsu Graphite Works Co.,Ltd. was used.

### (Example 2)

Except that oil-furnace black (manufactured by Asahi Carbon Co., Ltd., Product name "F-200 GS", BET specific surface area: 55 m²/g, DBP oil absorption amount: 180 ml/100 g, primary particle diameter: 38 nm) was used as the carbon black (B), scale-like graphite (manufactured by Chuetsu Graphite Works Co., Ltd., Product name "CPB-100B", volume average particle size: 80 pm) was used as the graphite (D), and the contents of the carbon black (B), the carbon fibers (C), and the graphite (D) were changed as shown in Table 1 below, the same procedure as in Example 1 was carried out to obtain a resin composition.

### (Example 3)

Except that the pitch-based carbon fibers (Product name "K237SE" manufactured by Mitsubishi Chemical Corporation, weight average fiber length: 6 mm, fiber diameter: 11 µm) were used as the carbon fibers (C), and the contents of carbon black (B), carbon fibers (C), and graphite (D) were changed as shown in Table 1 below, the same procedure as in Example 2 was carried out to obtain a resin composition.

### (Example 4)

A resin composition was obtained in the same manner as in Example 1 except that oil-furnace black (manufactured by LION SPECIALTY CHEMICALS CO., Ltd., Product name "Lionite CB", BET specific surface area: 1052 m²/g) was used as the carbon black (B).

### (Example 5)

Except that the content of the carbon fibers (C) was changed to 20 parts by weight as shown in Table 1 below, the same procedure as in Example 1 was carried out to obtain a resin composition.

### (Example 6)

Except that the content of the graphite (D) was changed to 200 parts by weight as shown in Table 1 below, the same procedure as in Example 1 was carried out to obtain a resin composition.

### (Example 7)

Except that as the graphite (D), the scale-like graphite (Manufactured by Nippon Kokuen Group, Product name "FB-150", volume average particle size: 45 pm) was used instead of the scale-like graphite in Example 1, the same procedure as in Example 1 was carried out to obtain a resin composition.

### (Example 8)

A resin composition was obtained in the same manner as in Example 1 except that expanded graphite (Product name: "AED-02" manufactured by FUJIKOKUEN Co., Ltd, volume average particle size: 1000 µm) was used as the graphite (D) instead of the scale-like graphite in Example 1.

### (Comparative example 1)

Except that the carbon fibers (C) and the graphite (D) were not used, and the content of the carbon black (B) was changed as shown in Table 1 below, the same procedure as in Example 1 was carried out to obtain a resin composition.

### (Comparative example 2)

A resin composition was obtained in the same manner as in Example 2 except that the carbon black (B) and the graphite (D) were not used.

### (Comparative example 3)

Except that the carbon black (B) and the carbon fiber (C) were not used, and the content of the graphite (D) was changed as shown in Table 1 below, the same procedure as in Example 2 was carried out to obtain a resin composition.

### (Comparative example 4)

A resin composition was obtained in the same manner as in Example 1 except that Ketjen Black (Product name: "EC600J", BET specific surface area: 1270 m²/g, manufactured by LION SPECIALTY CHEMICALS CO., Ltd.) was used as the carbon black (B), PAN-based carbon fibers (Product name: "Torayca chopped carbon fiber" manufactured by Toray Industries, Inc., weight average fiber length: 3 mm, fiber diameter: 7 pm) were used as the carbon fibers (C), flaky graphite (Manufactured by Nippon Kokuen Group, Product name: "CB-100", volume average particle size: 100 µm) was used as the graphite (D), and the contents of the carbon black (B), the carbon fiber (C), and the graphite (D) were changed as shown in Table 1 below.

### (Comparative example 5)

Except that the graphite (D) was not used, and the contents of the carbon black (B) and the carbon fiber (C) were changed as shown in Table 1 below, the same procedure as in Example 1 was carried out to obtain a resin composition.

### [Evaluation]

### (Bending strength)

The resin compositions obtained in Examples 1 to 8 and Comparative Examples 1 to 5 was injection-molded to obtain a resin molded body of 80 mm length × 10 mm width × 4 mm thickness, which was a strip-shaped test piece conforming to ISO294-1, and the resin molded body was used as a measurement sample. The injection molding was performed under conditions of a resin temperature of 230°C, a mold temperature of 50°C, and an injection speed of 30 mm/s.

The bending strength of the obtained measurement sample was measured in accordance with ISO178. The bending strength was measured using a Tensilon universal tester (Manufactured by ORIENTEC CO., LTD, model number "RTC-1210A").

### (Electromagnetic wave shielding effect)

The resin composition obtained in Example 1 to 8 and Comparative Example 1 to 5 was injection-molded to obtain a resin molded body of 100 mm length × 100 mm width × 2 mm thickness, and the resin molded body was used as a measurement sample. The injection molding was performed under conditions of a resin temperature of 230°C, a mold temperature of 50°C, and an injection speed of 30 mm/s.

The electromagnetic wave shielding effect (electromagnetic wave shielding performance, unit: dB) at a frequency of 100 MHz of the obtained measurement sample was measured using a KEC method electric field shielding characteristic measuring jig (manufactured by Japan Shielded Enclosures Co.). Specifically, the electromagnetic wave was radiated from a focal point on the transmission side, and the intensity of the electromagnetic wave converged on the focal point on the reception side was measured as a reception voltage. The reception voltage V₀ when the sample was not inserted and the reception voltage V when the sample was inserted were measured, and the electromagnetic wave shielding effect was calculated according to the following Equation (2). Electromagnetic wave shielding effect =20 × log10 (V0/V)

### (Spiral-flow flow length)

The fluidity of the resin composition obtained in Examples 1 to 8 and Comparative Examples 1 to 5 was evaluated as a spiral-flow flow length. Specifically, the flow length was measured when injection molding was performed at a cylinder temperature of 230°C, a mold temperature of 40°C, and an injection pressure of 150 MPa using a mold for resin flow length measurement having an Archimedes spiral flow path having 20 mm width × 2 mm thickness.

### (Thermal conductivity)

The resin composition obtained in Example 1 to 8 and Comparative Example 1 to 5 was injection-molded to obtain a resin molded body of 100 mm length × 100 mm width × 2 mm thickness. The central portion of the obtained resin molded body was punched into a size of 10 mm length × 2 mm width × 2 mm thickness to prepare a measurement sample. The injection molding was performed under conditions of a resin temperature of 230°C, a mold temperature of 50°C, and an injection speed of 30 mm/s.

The thermal conductivity (in-plane direction) of the obtained measurement sample was measured using a product number "Xenon Flash Laser Analyzer LFA467 HyperFlash" manufactured by NETZSCH Japan K.K. Specifically, the measurement sample was fitted into the holder in a direction in which the thermal conductivity can be measured, the thermal diffusivity at 30°C was measured, and the thermal conductivity was calculated according to the following Equation (1). Thermal conductivity (W/(m·K)) = Specific gravity (g/cm3) × Specific heat (J/g-K) × Thermal diffusivity (mm2/s)

The results are shown in Tables 1 and 2 below.

**[Table 1]**

| | | Example 1 | Example 2 | Example 3 | Example 4 | Example 5 | Example 6 | Example 7 | Example 8 |
|---|---|---|---|---|---|---|---|---|---|
| Thermoplastic Resin (A) | Type | PP | PP | PP | PP | PP | PP | PP | PP |
| | Content (parts by weight) | 100 | 100 | 100 | 100 | 100 | 100 | 100 | 100 |
| Carbon black (B) | Type | Oil-furnace black | Oil-furnace black | Oil-furnace black | Oil-furnace black | Oil-furnace black | Oil-furnace black | Oil-furnace black | Oil-furnace black |
| | Content (parts by weight) | 30 | 80 | 20 | 30 | 30 | 30 | 30 | 30 |
| | BET specific surface area (m²/g) | 254 | 55 | 55 | 1052 | 254 | 254 | 254 | 254 |
| Carbon fiber (C) | Type | PAN-based | PAN-based | Pitch-based | PAN-based | PAN-based | PAN-based | PAN-based | PAN-based |
| | Content (parts by weight) | 40 | 50 | 65 | 40 | 20 | 40 | 40 | 40 |
| | Weight average fiber length (mm) | 6 | 6 | 6 | 6 | 6 | 5 | 6 | 6 |
| Graphite (D) | Type | Scale-like graphite | Scale-like graphite | Scale-like graphite | Scale-like graphite | Scale-like graphite | Scale-like graphite | Scale-like graphite | Expanded graphite |
| | Content (parts by weight) | 120 | 50 | 20 | 120 | 120 | 200 | 120 | 120 |
| | Volume average particle size (µm) | 300 | 80 | 80 | 300 | 300 | 300 | 45 | 1000 |
| Bending strength of resin molded body (MPa) | | 120 | 110 | 140 | 90 | 90 | 120 | 130 | 120 |
| Electromagnetic wave shielding performance (dB) of resin molded body at 100 MHz | | 60 | 60 | 50 | 65 | 45 | 65 | 50 | 65 |
| Spiral-flow flow length (mm) | | 180 | 180 | 230 | 110 | 200 | 80 | 200 | 60 |
| Thermal conductivity in in-plane direction (W/(m·K)) | | 7 | 3.5 | 1.5 | 7 | 7 | 10 | 5 | 12 |

**[Table 2]**

| | | Comparative Example 1 | Comparative Example 2 | Comparative Example 3 | Comparative Example 4 | Comparative Example 5 |
|---|---|---|---|---|---|---|
| Thermoplastic Resin (A) | Type | PP | PP | PP | PP | PP |
| | Content (parts by weight) | 100 | 100 | 100 | 100 | 100 |
| Carbon black (B) | Type | Oil-furnace black | - | - | Ketjen black | Oil-furnace black |
| | Content (parts by weight) | 60 | - | - | 8.5 | 20 |
| | BET specific surface area (m²/g) | 254 | - | - | 1270 | 254 |
| Carbon fiber (C) | Type | - | PAN-based | - | PAN-based | PAN-based |
| | Content (parts by weight) | - | 50 | - | 15 | 35 |
| | Weight average fiber length (mm) | - | 6 | - | 3 | 6 |
| Graphite (D) | Type | - | - | Scale-like graphite | Scale-like graphite | - |
| | Content (parts by weight) | - | - | 100 | 180 | - |
| | Volume average particle size (µm) | - | - | 80 | 100 | - |
| Bending strength of resin molded body (MPa) | | 35 | 200 | 35 | 60 | 120 |
| Electromagnetic wave shielding performance (dB) of resin molded body at 100 MHz | | 10 | 10 | 15 | 35 | 20 |
| Spiral-flow flow length (mm) | | 260 | 280 | 300 | 110 | 220 |
| Thermal conductivity in in-plane direction (W/(m·K)) | | 0.5 | 0.8 | 7 | 8 | 1 |

As is apparent from Table 1, the molded body of the resin composition of Examples 1 to 8 had a bending strength of 90 MPa or more and an electromagnetic wave shielding performance of 45dB or more. As is apparent from Table 2, the molded bodies of the resin compositions of Comparative Examples 1, 3, and 4 had a bending strength of 60 MPa or less, and the molded body of the resin composition of Comparative Examples 1 to 5 had electromagnetic wave shielding performance of 35dB or less. Therefore, it was confirmed that in the resin composition of Examples 1 to 8, both the mechanical strength and the electromagnetic wave shielding properties can be achieved at a high level as compared with the resin composition of Comparative Examples 1 to 5. In addition, it was confirmed that in the resin composition of Examples 1 to 3, 5, and 7, the fluidity of the resin composition at the time of molding could be enhanced, and the moldability was also excellent.

### EXPLANATION OF SYMBOLS

- 10:: Heat dissipation chassis
- 20:: Heat dissipation housing
- 30:: Heat sink

## Claims

1. A resin composition comprising: a thermoplastic resin (A); carbon black (B); carbon fibers (C); and graphite (D), wherein a content of the carbon black (B) is from 10 parts by weight or more and 100 parts by weight or less with respect to 100 parts by weight of the thermoplastic resin (A).

2. The resin composition according to claim 1, wherein a content of the carbon fibers (C) is 10 parts by weight or more and 100 parts by weight or less with respect to 100 parts by weight of the thermoplastic resin (A).

3. The resin composition according to claim 1 or 2, wherein the carbon black (B) has a BET specific surface area of 600 m²/g or less.

4. The resin composition according to any one of claims 1 to 3, wherein the carbon fibers (C) have a weight average fiber length of 0.5 mm or more and 15 mm or less.

5. The resin composition according to any one of claims 1 to 4, wherein the carbon black (B) is oil-furnace black.

6. The resin composition according to any one of claims 1 to 5, wherein a content of the graphite (D) is 10 parts by weight or more and 200 parts by weight or less with respect to 100 parts by weight of the thermoplastic resin (A) .

7. The resin composition according to any one of claims 1 to 6, wherein when a mold is filled with the resin composition in a molten state from a direction orthogonal to a thickness direction of a resin molded body to be obtained and molded to obtain a resin molded body of 100 mm length × 100 mm width × 2 mm thickness, an electromagnetic wave shielding effect at a frequency of 100 MHz of the resin molded body is 20 dB or more, and
when the resin composition is molded in accordance with ISO294-1 to obtain a strip-shaped resin molded body, a bending strength of the strip-shaped resin molded body measured in accordance with ISO178 is 40 MPa or more.

8. The resin composition according to any one of claims 1 to 7, wherein when a mold is filled with the resin composition in a molten state from a direction orthogonal to a thickness direction of a resin molded body to be obtained and molded to obtain a resin molded body of 100 mm length × 100 mm width × 2 mm thickness, a thermal conductivity in in-plane direction in a main surface of the resin molded body is 1.0 W/(m-K) or more.

9. A resin molded body which is a molded body of the resin composition according to any one of claims 1 to 8.

10. The resin molded body according to claim 9, wherein the resin molded body has a heat dissipation chassis, a heat dissipation housing, or a heat sink shape.
